# EUROPEAN PATENT APPLICATION

(11) **EP 4 350 826 A2**
(43) Date of publication of application: **10.04.2024**
(21) Application number: 23201436.5
(22) Date of filing: 03.10.2023
(51) Int. Cl.: H01M 10/04, H01M 10/48, H01M 50/186, H01M 50/543, H01M 50/569

(54) **POWER STORAGE DEVICE**

(30) Priority: 07.10.2022 JP 2022162052
(71) Applicant: TOYOTA JIDOSHA KABUSHIKI KAISHA, Toyota-shi, Aichi-ken, 471-8571 (JP)
(72) Inventor: NAKAYAMA, Hiroyuki, Toyota-shi, 471-8571 (JP); OKAMOTO, Yuki, Toyota-shi, 471-8571 (JP); ISHIGURO, Fumihiko, Toyota-shi, 471-8571 (JP); HIROSE, Takayuki, Toyota-shi, 471-8571 (JP)
(74) Representative: D Young & Co LLP

(57) **Abstract**

A power storage device (1) comprises: an electrode stack (100) comprising a plurality of bipolar electrodes (110) and a pair of outermost current collectors (130); an inner voltage detection terminal (300); a housing (400); and a pair of outer voltage detection terminals (700). Each of the plurality of bipolar electrodes (110) has a current collector (111), a positive electrode active material layer (112), and a negative electrode active material layer (113). The inner voltage detection terminal (300) is electrically connected to the current collector (111). Each of the pair of outer voltage detection terminals (700) is thicker than the inner voltage detection terminal (300). The housing (400) is located between the pair of outer voltage detection terminals (700) in the stacking direction. A dimension (T1) of the housing (400) in the stacking direction is equal to or less than a distance (T3) between the pair of outer voltage detection terminals (700) in the stacking direction.

## Description

### CROSS REFERENCE TO RELATED APPLICATIONS

This nonprovisional application is based on Japanese Patent Application No. 2022-162052 filed on October 7, 2022, with the Japan Patent Office, the entire contents of which are hereby incorporated by reference.

### BACKGROUND

### Field

The present disclosure relates to a power storage device.

### Description of the Background Art

Japanese Patent Laying-Open No. 2020-61221 discloses a bipolar battery comprising a plurality of bipolar electrodes and a voltage detection terminal connected to a current collector in each bipolar electrode.

### SUMMARY

In the bipolar battery described in Japanese Patent Laying-Open No. 2020-61221, the voltage detection terminal can be sometimes supported by a housing and, in that case, if another voltage detection terminal is connected to an outermost cell in the stacking direction, the length of the housing in the stacking direction increases. As a result, the entire size of the power storage device increases.

An object of the present disclosure is to provide a power storage device that can avoid an increase in size.

A power storage device according to an aspect of the present disclosure comprises: an electrode stack comprising a plurality of bipolar electrodes stacked on top of one another and a pair of outermost current collectors located outside of a set of the plurality of bipolar electrodes in a stacking direction of the plurality of bipolar electrodes; at least one inner voltage detection terminal connected to at least one of the plurality of bipolar electrodes; a housing supporting at least one of the at least one inner voltage detection terminal; and a pair of outer voltage detection terminals electrically connected respectively to the pair of outermost current collectors, wherein each of the plurality of bipolar electrodes has: a current collector; a positive electrode active material layer provided on one side of the current collector; and a negative electrode active material layer provided on the other side of the current collector, the inner voltage detection terminal is electrically connected to the bipolar electrode, each of the pair of outer voltage detection terminals is thicker than the at least one inner voltage detection terminal, the housing is located between the pair of outer voltage detection terminals in the stacking direction, and a dimension of the housing in the stacking direction is equal to or less than a distance between the pair of outer voltage detection terminals in the stacking direction.

The foregoing and other objects, features, aspects and advantages of the present disclosure will become more apparent from the following detailed description of the present disclosure when taken in conjunction with the accompanying drawings.

### BRIEF DESCRIPTION OF THE DRAWINGS

Fig. 1 is a cross-sectional view schematically illustrating a power storage device according to an embodiment of the present disclosure.
Fig. 2 is a plan view of an outer current collector plate, an outer voltage detection terminal, and an insulating member in a power storage device.
Fig. 3 is a cross-sectional view at Line III-III in Fig. 2.
Fig. 4 is a plan view schematically illustrating a modification of the state of insulation between an outer current collector plate and an outer voltage detection terminal.
Fig. 5 is a cross-sectional view at Line V-V in Fig. 4.
Fig. 6 is a plan view schematically illustrating a modification of the state of insulation between an outer current collector plate and an outer voltage detection terminal.
Fig. 7 is a cross-sectional view at Line VII-VII in Fig. 6.
Fig. 8 is a plan view schematically illustrating a modification of the state of insulation between an outer current collector plate and an outer voltage detection terminal.
Fig. 9 is a cross-sectional view at Line IX-IX in Fig. 8.
Fig. 10 is a plan view schematically illustrating a modification of the state of insulation between an outer current collector plate and an outer voltage detection terminal.
Fig. 11 is a cross-sectional view at Line XI-XI in Fig. 10.

### DESCRIPTION OF THE PREFERRED EMBODIMENTS

A description will be given of an embodiment of the present disclosure, with reference to drawings. In the drawings referenced below, the same or equivalent members are denoted by the same numeral.

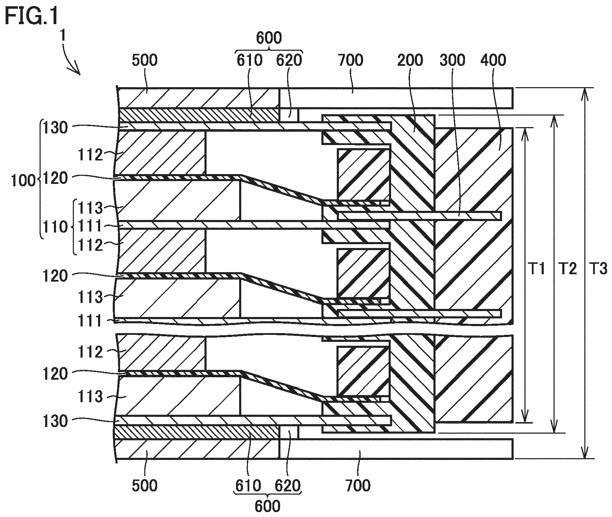

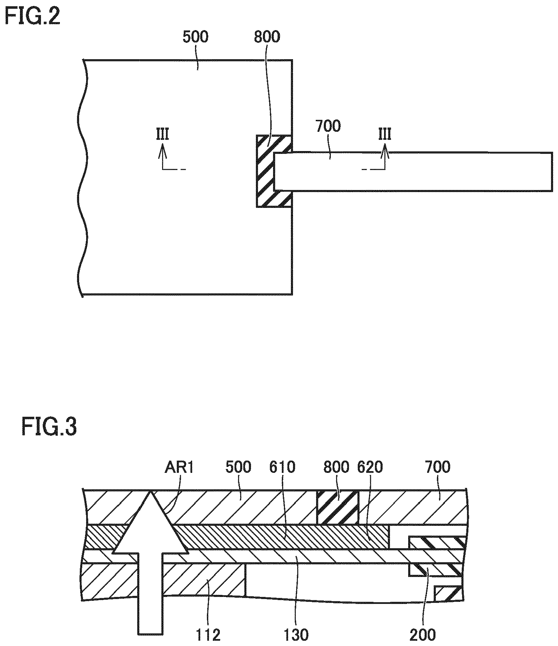

Fig. 1 is a cross-sectional view schematically illustrating a power storage device according to an embodiment of the present disclosure. As illustrated in Fig. 1, a power storage device 1 comprises an electrode stack 100, a sealing member 200, at least one inner voltage detection terminal 300, a housing 400, a pair of outer current collector plates 500, an electrically-conductive adhesive 600, a pair of outer voltage detection terminals 700, and an insulating member 800 (see Fig. 2).

Electrode stack 100 has a plurality of bipolar electrodes 110, a plurality of separators 120, and a pair of outermost current collectors 130.

Bipolar electrodes 110 are stacked on top of one another. Each bipolar electrode 110 has a current collector 111, a positive electrode active material layer 112, and a negative electrode active material layer 113.

Current collector 111 is made of metal, for example. Current collector 111 is formed in a rectangular shape, for example.

Positive electrode active material layer 112 is provided on one side (the lower side in Fig. 1) of current collector 111.

Negative electrode active material layer 113 is provided on the other side (the upper side in Fig. 1) of current collector 111.

Bipolar electrodes 110 are stacked in a manner that positive electrode active material layer 112 of one bipolar electrode 110 faces negative electrode active material layer 113 of another bipolar electrode 110 that is adjacent to the one bipolar electrode 110.

Separator 120 is interposed between positive electrode active material layer 112 and negative electrode active material layer 113. Separator 120 has functions to allow ions to pass through itself and to insulate positive electrode active material layer 112 from negative electrode active material layer 113 for avoiding their direct contact. The thickness of separator 120 may be less than both the thickness of positive electrode active material layer 112 and the thickness of negative electrode active material layer 113.

Each outermost current collector 130 is located outside of a set of the plurality of bipolar electrodes 110 in the stacking direction of the plurality of bipolar electrodes 110 (the vertical direction in Fig. 1). On one outermost current collector 130, only positive electrode active material layer 112 is provided facing negative electrode active material layer 113 of bipolar electrode 110 that is adjacent to this outermost current collector 130 with separator 120 present therebetween; and on the other outermost current collector 130, only negative electrode active material layer 113 is provided facing positive electrode active material layer 112 of bipolar electrode 110 that is adjacent to this outermost current collector 130 with separator 120 present therebetween.

A pair of current collectors 111 that are adjacent to each other in the stacking direction, in combination with positive electrode active material layer 112, separator 120, and negative electrode active material layer 113 located between the pair of current collectors 111, constitute a single cell. That is, electrode stack 100 is constituted of a plurality of cells stacked on top of one another; and the current collector disposed outside of the outermost cell, which is a cell among the plurality of cells that is located outermost in the stacking direction, constitutes outermost current collector 130.

In a bipolar battery constituted of a plurality of cells stacked on top of one another, each bipolar electrode 110 serves as both the positive electrode of a cell and the negative electrode of an adjacent cell, and the plurality of cells are connected to each other in series.

Sealing member 200 seals an inner space that is formed between a pair of current collectors that are adjacent to each other in the stacking direction. Sealing member 200 is made of an insulating member. Sealing member 200 supports an end, in a direction orthogonal to the stacking direction, of each of current collector 111, outermost current collector 130, and separator 120. In the present embodiment, the inner space is filled with an electrolyte solution. Alternatively, each cell of electrode stack 100 may be constituted of a so-called all-solid-state battery having a solid electrolyte. In this case, separator 120 is not present.

Inner voltage detection terminal 300 is electrically connected to bipolar electrode 110 located on the inside of the pair of outermost current collectors 130 in the stacking direction. Specifically, inner voltage detection terminal 300 is connected to current collector 111 and sticks out from sealing member 200. In the present embodiment, at least one inner voltage detection terminal 300 comprises the same number of inner voltage detection terminal 300 as the number of current collector 111, and each inner voltage detection terminal 300 is connected to current collector 111. Alternatively, the number of inner voltage detection terminal 300 may be less than the number of current collector 111. In this case, one inner voltage detection terminal 300 is connected for a certain number of current collectors 111 aligned in the stacking direction. In other words, among a plurality of current collectors 111 aligned in the stacking direction, there may be a current collector 111 to which inner voltage detection terminal 300 is not connected. Inner voltage detection terminal 300 protrudes from sealing member 200 in a direction orthogonal to the stacking direction, for example. The thickness of inner voltage detection terminal 300 is approximately from 0.05 mm to 0.1 mm. Inner voltage detection terminal 300 is connected to a detection circuit (not illustrated). As for current collectors 111 the inner voltage detection terminals 300 of which are present side by side, the positions of inner voltage detection terminals 300 are not aligned in a direction orthogonal to the stacking direction.

Housing 400 supports inner voltage detection terminal 300. Housing 400 is made of an insulating material. Housing 400 is secured to the outer side of sealing member 200 in a direction orthogonal to the stacking direction. The size of housing 400 is designed so that it is capable of supporting inner voltage detection terminal 300. As illustrated in Fig. 1, a dimension T1 of housing 400 in the stacking direction is preferably designed to be equal to or less than a length T2 of sealing member 200 in the stacking direction. Dimension T1 of housing 400 in the stacking direction may be designed to be equal to or less than a distance T3 between the outer surfaces of the pair of outer voltage detection terminals 700 in the stacking direction.

Each outer current collector plate 500 is located outside of electrode stack 100 in the stacking direction. More specifically, each outer current collector plate 500 is located outside of outermost current collector 130 in the stacking direction. As illustrated in Fig. 2, each outer current collector plate 500 is formed in a rectangular shape, for example. The thickness of each outer current collector plate 500 is designed to be approximately from 0.5 mm to 3 mm.

Electrically-conductive adhesive 600 is provided on the outer surface of outermost current collector 130 in the stacking direction.

Each outer voltage detection terminal 700 is electrically connected to outermost current collector 130. More specifically, as illustrated in Fig. 1 and Fig. 3, each outer voltage detection terminal 700 is electrically connected to outermost current collector 130 with electrically-conductive adhesive 600 present therebetween. That is, electrically-conductive adhesive 600 has a first adhesive part 610 that is electrically conductive and that connects outermost current collector 130 with outer current collector plate 500, as well as a second adhesive part 620 that is electrically conductive and that connects outermost current collector 130 with outer voltage detection terminal 700. Each outer voltage detection terminal 700 is connected to a detection circuit (not illustrated).

The thickness of each outer voltage detection terminal 700 may be the same as, or different from, the thickness of each outer current collector plate 500. The thickness of each outer voltage detection terminal 700 is simply required to be sufficient for maintaining enough rigidity to prevent the outer voltage detection terminal 700 from bending by its own weight, and, for example, it is approximately from 0.5 mm to 3 mm. The thickness of outer voltage detection terminal 700 is designed to be equal to or less than the thickness of outer current collector plate 500, for example. The outer surface of outer voltage detection terminal 700 in the stacking direction may be formed flush with the outer surface of outer current collector plate 500 in the stacking direction. This configuration makes it possible to avoid distance T3 from being larger than the distance between the outer surfaces of the pair of outer current collector plates 500 in the stacking direction.

Each outer voltage detection terminal 700 protrudes from outer current collector plate 500, in the same direction as inner voltage detection terminal 300 protrudes from sealing member 200 (the direction to the right in Fig. 1 and Fig. 2). As illustrated in Fig. 2, the width of outer voltage detection terminal 700 in a direction that is orthogonal to the direction in which outer voltage detection terminal 700 protrudes from outer current collector plate 500 as well as to the stacking direction (namely, in the vertical direction in Fig. 2) is less than the width of outer current collector plate 500 in the same, orthogonal direction.

Each outer voltage detection terminal 700 is located outside of sealing member 200 in the stacking direction. Each outer voltage detection terminal 700 is located outside of housing 400 in the stacking direction.

Insulating member 800 is interposed between outer voltage detection terminal 700 and outer current collector plate 500. Insulating member 800 insulates outer current collector plate 500 from outer voltage detection terminal 700. Insulating member 800 is formed by insert molding, application of an electrically-insulating adhesive, and/or the like. In Fig. 2, insulating member 800 is marked with oblique lines.

In the direction indicated by an arrow AR1 in Fig. 3, a large current flows from electrode stack 100 through first adhesive part 610 toward outer current collector plate 500, and detection of the voltage of outermost current collector 130 by outer voltage detection terminal 700 is made possible by second adhesive part 620 interposed between outer voltage detection terminal 700 and outermost current collector 130. Passage of current from outer current collector plate 500 to outer voltage detection terminal 700 is interrupted by insulating member 800.

As described above, in power storage device 1 according to the present embodiment, each outer voltage detection terminal 700 is thicker than inner voltage detection terminal 300 so that bending of outer voltage detection terminal 700 by its own weight is reduced as compared to inner voltage detection terminal 300, and thereby outer voltage detection terminal 700 does not need to be supported by the housing; and, furthermore, dimension T1 of housing 400 in the stacking direction is equal to or less than distance T3 between the pair of outer voltage detection terminals 700 in the stacking direction, and thereby an increase in the size of power storage device 1 is avoided.

Moreover, in a case when a power storage device is composed of a stack of a plurality of power storage modules each comprising stacked cells and housing 400, these power storage modules aligned in the stacking direction are spaced from each other so as to avoid contact between adjacent power storage modules. Because of this, when dimension T1 of housing 400 in the stacking direction is more than distance T3 between the pair of outer voltage detection terminals 700 in the stacking direction, the thickness of outer current collector plate 500 interposed between adjacent power storage modules increases; on the other hand, in power storage device 1 according to the present embodiment, where dimension T1 of housing 400 in the stacking direction is equal to or less than distance T3 between the pair of outer voltage detection terminals 700 in the stacking direction, an increase in the thickness of outer current collector plate 500 is avoided and thereby an increase in the total size of the power storage device is avoided.

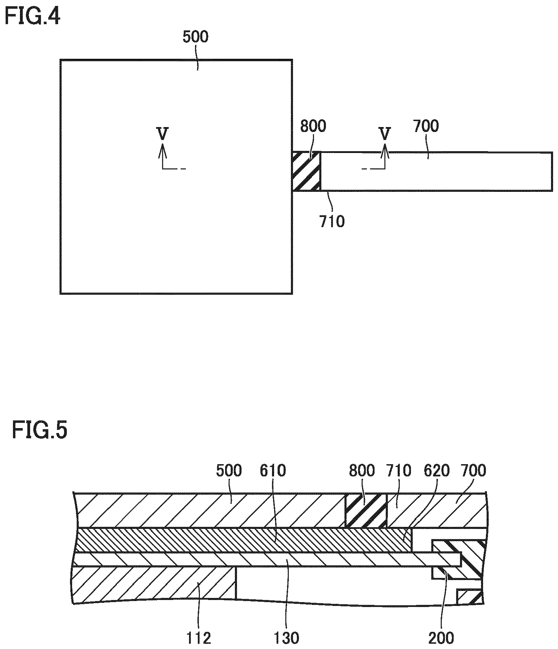

In this embodiment, as illustrated in Fig. 4 and Fig. 5, insulating member 800 may be interposed between outer current collector plate 500 and a base end 710 of outer voltage detection terminal 700.

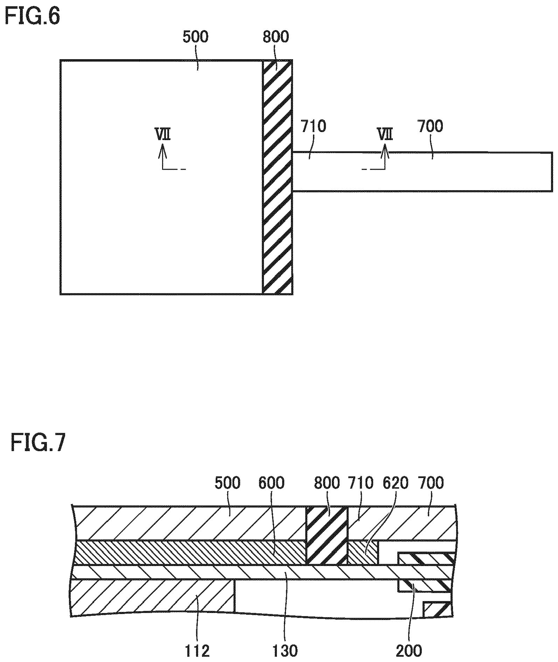

As illustrated in Fig. 6 and Fig. 7, insulating member 800 may be interposed between an end of outer current collector plate 500 to which outer voltage detection terminal 700 is connected (the end to the right in Fig. 6) and outer voltage detection terminal 700.

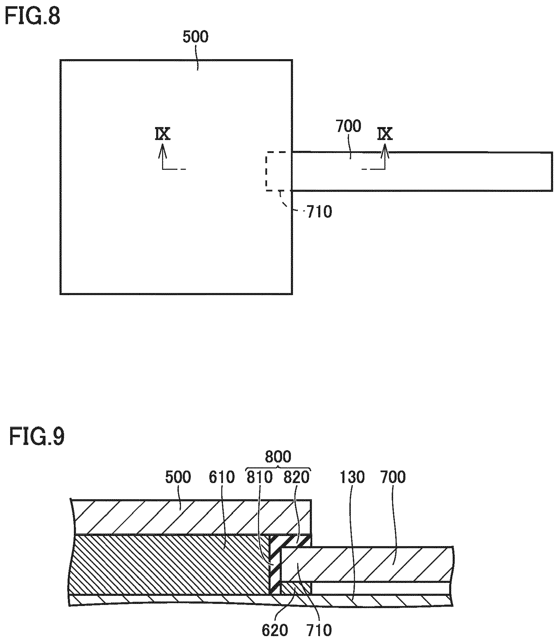

As illustrated in Fig. 8 and Fig. 9, when electrically-conductive adhesive 600 is formed thicker than outer voltage detection terminal 700, base end 710 of outer voltage detection terminal 700 may be buried inside electrically-conductive adhesive 600 through insulating member 800. That is, insulating member 800 may have a covering portion 810 covering the end face of base end 710, as well as an interposed portion 820 interposed between outer current collector plate 500 and base end 710.

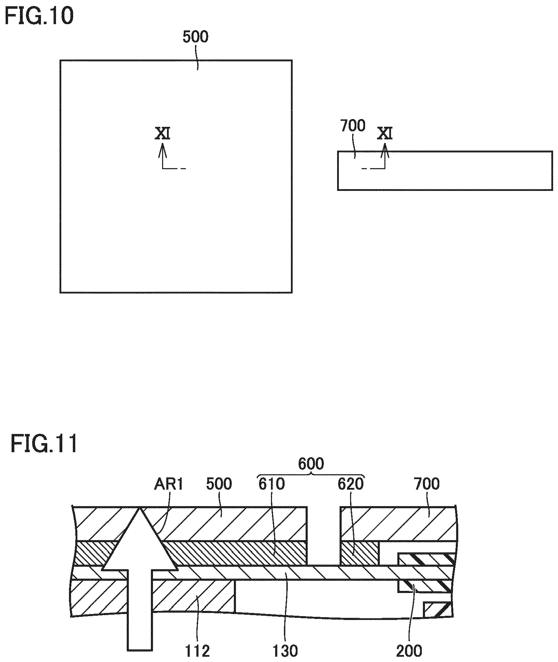

As illustrated in Fig. 10 and Fig. 11, outer voltage detection terminal 700 may be spaced from outer current collector plate 500. That is, outer current collector plate 500 may be insulated from outer voltage detection terminal 700 by the presence of space. In this case, insulating member 800 is not present. Also in this case, the distance between the outer surfaces of the pair of outer voltage detection terminals 700 is designed to be equal to or less than the distance between the outer surfaces of the pair of outer current collector plates 500.

A person skilled in the art will appreciate that the above-described example embodiment is a specific example of the following aspects.

### [Aspect 1]

A power storage device comprising:
an electrode stack comprising:
   a plurality of bipolar electrodes stacked on top of one another; and
   a pair of outermost current collectors located outside of a set of the plurality of bipolar electrodes in a stacking direction of the plurality of bipolar electrodes;
at least one inner voltage detection terminal connected to at least one of the plurality of bipolar electrodes;
a housing supporting at least one of the at least one inner voltage detection terminal; and
a pair of outer voltage detection terminals electrically connected respectively to the pair of outermost current collectors, wherein
each of the plurality of bipolar electrodes has:
   a current collector;
   a positive electrode active material layer provided on one side of the current collector; and
   a negative electrode active material layer provided on the other side of the current collector,
the at least one inner voltage detection terminal is electrically connected to the bipolar electrode,
each of the pair of outer voltage detection terminals is thicker than the at least one inner voltage detection terminal,
the housing is located between the pair of outer voltage detection terminals in the stacking direction, and
a dimension of the housing in the stacking direction is equal to or less than a distance between the pair of outer voltage detection terminals in the stacking direction.

In this power storage device, each outer voltage detection terminal is thicker than the inner voltage detection terminal, and thereby the outer voltage detection terminal does not need to be supported by the housing; and, furthermore, the dimension of the housing in the stacking direction is equal to or less than the distance between the pair of outer voltage detection terminals in the stacking direction, and thereby an increase in the size of the power storage device is avoided.

### [Aspect 2]

The power storage device according to Aspect 1, further comprising a sealing member that seals an inner space formed between a pair of the current collectors that are adjacent to each other in the stacking direction, wherein
the sealing member is located between the pair of outer voltage detection terminals, and
the dimension of the housing in the stacking direction is equal to or less than a length of the sealing member in the stacking direction.

In this aspect, the housing can more reliably support the inner voltage detection terminal, and an increase in the size of the power storage device is more reliably avoided.

### [Aspect 3]

The power storage device according to Aspect 1 or 2, further comprising:
an outer current collector plate located on an outside of the electrode stack in the stacking direction;
a first adhesive part that is electrically conductive and connects the outermost current collector with the outer current collector plate; and
a second adhesive part that is electrically conductive and connects the outermost current collector with the outer voltage detection terminal, wherein
the outer voltage detection terminal is electrically insulated from the outer current collector plate.

In this aspect, the outer voltage detection terminal is electrically insulated from the outer current collector plate, and thereby a decrease in the accuracy of the voltage measurement at the detection circuit connected to the outer voltage detection terminal, which can occur due to a voltage drop caused by resistance of the first adhesive part, is reduced, as compared to when a relatively large current, which has flown from the electrode stack through the first adhesive part to the outer current collector plate, flows from the outer current collector plate to the outer voltage detection terminal.

### [Aspect 4]

The power storage device according to Aspect 3, further comprising an insulating member interposed between the outer voltage detection terminal and the outer current collector plate.

### [Aspect 5]

The power storage device according to Aspect 3, wherein the outer voltage detection terminal is spaced from the outer current collector plate.

### [Aspect 6]

The power storage device according to any one of Aspects 3 to 5, wherein the distance between the pair of outer voltage detection terminals in the stacking direction is equal to or less than a distance between the pair of outermost current collectors in the stacking direction.

In this aspect, as compared to when all the detection terminals are supported by the housing, the size of the power storage device in the stacking direction is decreased.

Although the embodiments of the present disclosure have been described, the embodiments disclosed herein are illustrative and non-restrictive in any respect. The scope of the present disclosure is defined by the terms of the claims, and is intended to encompass any modifications within the meaning and the scope equivalent to the terms of the claims.

## Claims

1. A power storage device (1) comprising:
an electrode stack (100) comprising:
a plurality of bipolar electrodes (110) stacked on top of one another; and
a pair of outermost current collectors (130) located outside of a set of the plurality of bipolar electrodes in a stacking direction of the plurality of bipolar electrodes;
at least one inner voltage detection terminal (300) connected to at least one of the plurality of bipolar electrodes;
a housing (400) supporting at least one of the at least one inner voltage detection terminal; and
a pair of outer voltage detection terminals (700) electrically connected respectively to the pair of outermost current collectors, wherein
each of the plurality of bipolar electrodes has:
a current collector (111);
a positive electrode active material layer (112) provided on one side of the current collector; and
a negative electrode active material layer (113) provided on the other side of the current collector,
the inner voltage detection terminal is electrically connected to the bipolar electrode,
each of the pair of outer voltage detection terminals is thicker than the at least one inner voltage detection terminal,
the housing is located between the pair of outer voltage detection terminals in the stacking direction, and
a dimension (T1) of the housing in the stacking direction is equal to or less than a distance (T3) between the pair of outer voltage detection terminals in the stacking direction.

2. The power storage device according to claim 1, further comprising a sealing member (200) that seals an inner space formed between a pair of the current collectors that are adjacent to each other in the stacking direction, wherein
the sealing member is located between the pair of outer voltage detection terminals, and
the dimension of the housing in the stacking direction is equal to or less than a length (T2) of the sealing member in the stacking direction.

3. The power storage device according to claim 1 or 2, further comprising:
an outer current collector plate (500) located on an outside of the electrode stack in the stacking direction;
a first adhesive part (610) that is electrically conductive and connects the outermost current collector with the outer current collector plate; and
a second adhesive part (620) that is electrically conductive and connects the outermost current collector with the outer voltage detection terminal, wherein
the outer voltage detection terminal is electrically insulated from the outer current collector plate.

4. The power storage device according to claim 3, further comprising an insulating member (800) interposed between the outer voltage detection terminal and the outer current collector plate.

5. The power storage device according to claim 3, wherein the outer voltage detection terminal is spaced from the outer current collector plate.

6. The power storage device according to claim 3, wherein the distance between the pair of outer voltage detection terminals in the stacking direction is equal to or less than a distance between the pair of outermost current collectors in the stacking direction.
